Europäisches Patentamt

European Patent Office

Office européen des brevets

(19)

(11) **EP 1 302 248 A2**

(12) **EUROPEAN PATENT APPLICATION**

(43) Date of publication:
  **16.04.2003 Bulletin 2003/16**

(51) Int Cl.7: **B05D 3/06**, C23C 16/44,
  C23C 16/26, C23C 16/50

(21) Application number: **03001217.3**

(22) Date of filing: **08.05.1992**

(84) Designated Contracting States:
  **DE FR GB**

(30) Priority: **10.05.1991 US 698538**
  **10.05.1991 US 698446**

(62) Document number(s) of the earlier application(s) in
  accordance with Art. 76 EPC:
  **99119093.5 / 0 969 120**
  **92911953.5 / 0 583 374**

(71) Applicant: **CELESTECH, INC.**
  **Irvine, CA 92178 (US)**

(72) Inventors:
  • **Cann, Gordon L.**
    **Laguna Beach, CA 92651 (US)**
  • **Shepard, Cecil B., Jr.**
    **Anaheim Hills, CA 92807 (US)**
  • **McKevitt, Frank L.**
    **Anaheim Hills, CA 92807 (US)**

(74) Representative: **Skone James, Robert Edmund**
  **GILL JENNINGS & EVERY**
  **Broadgate House**
  **7 Eldon Street**
  **London EC2M 7LH (GB)**

Remarks:
  This application was filed on 20 - 01 - 2003 as a
  divisional application to the application mentioned
  under INID code 62.

(54) **Method and appartus for plasma deposition**

(57)   The disclosure is directed to a plasma jet deposition method and apparatus for depositing a substance, such as synthetic diamond. A plasma beam containing constituents of the substance to be deposited is produced. A substrate (150) is provided, and has a surface in the path of the beam, the area of said surface being substantially larger than the cross-sectional area of the beam impinging on the surface. Repetitive motion is introduced between the substrate and the beam as the substrate is deposited on the surface. The substrate in a plasma jet deposition system can be provided with structural attributes, such as apertures (170) and/or grooves (168), that facilitate efficient deposition. Groups of substrates (610,620,630 and 640) can be arranged with surfaces generally along the envelope of plasma beam to facilitate efficient deposition.

Fig. 1

**Description**

FIELD OF THE INVENTION

This invention relates to plasma deposition of substances and, more particularly, to plasma deposition on a substrate of films of material such as synthetic diamond by techniques utilizing a plasma jet.

BACKGROUND OF THE INVENTION

Techniques for depositing substances, such as layers of semiconductor material, using a plasma that is formed into a jet, are well known. For example, my U.S. Patent No.s 4,471,003 and 4,487,162 disclose arc jet plasma deposition equipment which utilizes a plasma for deposition of semiconductors and other materials. Ions and electrons are obtained by injecting an appropriate compound, such as a silicon compound, into an arc region, and a jet (or beam) is formed by utilizing magnetic fields to accelerate and focus the plasma. Recently, equipment of this type has been used to deposit synthetic diamond. Superior physical and chemical properties make diamond desirable for many mechanical, thermal, optical and electronic applications, and the ability to deposit synthetic diamond by plasma jet deposition holds great promise, particularly if plasma jet techniques can be improved for this and other purposes.

In plasma jet deposition techniques there are various factors which limit the practical size of the deposition area that is active on a substrate at a particular moment. For example, when an arc is employed to generate the heated gas mixture in an arc jet plasma deposition system, the diameter of the effluent beam can be limited by a number of factors. For practical reasons the orifice from the arc chamber is of limited area. If the gas is expanded supersonically, the exit area of the nozzle will be determined by the pumping rate of the vacuum pumping system, so the vacuum pumping capability is a limiting factor in this regard. Expansion of the gas subsonically can result in heat transfer to the nozzle walls and significantly reduce the gas enthalpy. Also, the number density of key species in the flow can be degraded by volume reactions. Further, overly expanding the beam can diminish economic efficiency since the diamond yield may depend on the carbon impingement rate or upon the power density.

In various commercial applications it is desirab , or may become desirable, to have relatively large size diamond films. Since, for reasons just summarized, among others, the cross-section of the plasma beam is generally limited in practical applications, the area on which it is desired to deposit a diamond film may be many times larger than the deposition beam. This means that the beam and the target substrate need to be moved with respect to each other during the deposition process, which gives rise to a number of problems. The film will have a temperature gradient associated with power density from the impinging jet, and the film will tend to experience thermal cycling as the substrate moves with respect to the beam. The temperature gradients and/or thermal cycling tend to stress the diamond film, and can cause it to crack or spall off the substrate. Even if the film remains intact on the substrate, it may contain internal stress defects that can render it unacceptable for the purpose for which it was intended.

It is among the objects of the present invention to provide an apparatus and method which is responsive to the prior art limitations and problems described above and which facilitates production of relatively large area films, such as diamond films, of improved properties and with improved production efficiency.

When a heated plasma jet impinges on a substrate, a significant fraction of the plasma beam is channeled around the substrate without coming in contact with the substrate surface. The energy invested in processing the bypassing portion of the flow into the necessary species of the plasma (e.g. carbon molecules, radicals, and atomic hydrogen, for the case of diamond deposition) does not result in effective deposition, and this substantially increases the cost of the process. Inefficient deposition also increases the time necessary to obtain a desired layer thickness and can waste constituent feedstock. Recycling of feedstock (particularly hydrogen) is possible, but also involves some cost.

It is among the further objects of the present invention to improve the efficiency of plasma jet deposition of substances.

US-A-4,292,342 describes a method in which polycrystalline silicon is deposited on the interior surface of a shaped container. The silicon is deposited by reacting hydrogen and a silicon bearing gas in the presence of a high pressure plasma. The silicon body is separated from the shaped container by utilizing thermal expansion shear stress.

JP-A-59043861 illustrates a chemical vapour deposition device which expands a uniformly coatable region and has improved workability by holding substrates in the form of a louver with respect to the flow of reacting gas in a reaction chamber.

SUMMARY OF THE INVENTION

In accordance with a feature of the present invention, the temperature variation of a substrate and a substance being deposited thereon is controlled, both temporally and spatially, by moving the substrate and the deposition beam with respect to each other at a rate which results in no more than a certain maximum temperature variation for specified operating conditions.

The invention is directed to a method and apparatus for depositing a substance, such as synthetic diamond. A plasma beam is produced, and contains the constituents of the substance to be deposited. [As used herein, the term "beam" is intended to generically include the terms beam and jet.] In a form of the invention, a substrate is provided, and has a surface (that is, at least one surface) in the path of the beam, the area of said surface being substantially larger than the cross-sectional area of the beam impinging on the surface. Repetitive motion (that is, motion in a pattern that substantially repeats) is introduced between the substrate and the beam as the substance is deposited on the surface. The substrate, the beam, or both can be moved. Spinning of the substrate, with the beam non-concentric thereon, is one preferred technique. The substrate can be tilted at a substantial angle (at least 10 degrees) with respect to the plane perpendicular to the beam direction, and the step of repetitively moving the substrate with respect to the beam may comprise moving the substrate back and forth with a component of motion perpendicular to the direction of the beam.

In general, when spinning of the substrate is employed, a rotation rate of at least about 500 rpm is preferred, with substantially higher rates of several thousand rpm being recommended for most situations. As described hereinbelow, factors such as the beam energy, the beam and substrate coverage geometries, and the properties of the substrate material all enter into the computation of the velocity (of the substrate and beam with respect to each other) that is necessary to keep temperature variations under control. Selection of substrate materials having favorable properties, particularly density and thermodynamic properties, will tend to reduce the velocity needed to attain a particular temperature deviation limit. Copper, tungsten, molybdenum, tungsten carbide, and molybdenum carbide have relatively favorable properties. Other attributes which should be taken into account pertain to the compatibility with the substance being deposited, including retention of the substance on the substrate, and the relative coefficients of expansion.

In accordance with a feature of the present invention, the substrate in a plasma deposition system is provided with structural attributes that facilitate efficient deposition. In a further form of the invention, groups of substrates are arranged with respect to the plasma beam in a manner which also facilitates efficient deposition. Applicant has found that, in addition to increasing the portion of the plasma beam volume which contacts the substrate surface or surfaces, it is advantageous to provide for the efficient evacuation of "spent fluids" (i.e. the remaining parts, mostly gasses, of an elemental volume of plasma which has deposited its operative species on the substrate) away from the substrate so that fresh plasma containing the operative species can easily and continuously contact the substrate surface.

In an embodiment of a form of the invention, grooves, apertures, or both are provided in the substrate, and function to channel spent fluids of the plasma beam away from the deposition surface of the substrate to permit more efficient deposition on the substrate by the operative species of the plasma. In another embodiment of this form of the invention, groups of substrates are provided, with openings between the substrates for evacuation of spent fluids.

In accordance with a further feature of the invention, a plurality of substrates are provided having surfaces generally along the envelope of the beam such that constituents (or operative species) in the peripheral region of the beam are applied to the surfaces. The plasma beam can be divided into a plurality of beam portions, and substrates provided with surfaces along the envelopes of the beam portions. At advancing positions in the beam propagation direction, the surfaces of the substrates can be at successively smaller radial distances from the axis of the beam. In this manner, as the beam is consumed [by deposition, and by evacuation of spent fluids through openings in substrates or between the substrates], the substrates continue to approximately envelop the periphery of a remaining smaller beam.

Further features and advantages of the invention will become more readily apparent from the following detailed description when taken in conjunction with the accompanying drawings.

BRIEF DESCRIPTION OF THE DRAWINGS

Fig. 1 is a diagram, partially in schematic form, of an apparatus in accordance with an embodiment of the invention and which can be utilized to practice an embodiment of the method of the invention.

Fig. 2 is a diagram, partially broken away, of a portion of the Fig. 1 apparatus in accordance with another embodiment of the invention.

Fig. 3 illustrates the beam impingement area of the Fig. 2 embodiment.

Fig. 4 is a diagram, partially in schematic form, of an apparatus which can be utilized to practice another embodiment of the invention.

Fig. 5 is a diagram of the stand of the Fig. 4 apparatus.

Fig. 6 is a top view of an embodiment of a substrate in accordance with a form of the invention.

Fig. 7 is a top view of another embodiment of a substrate in accordance with a form of the invention.

Fig. 8 is a top view of another embodiment of a substrate in accordance with a form of the invention.

Fig. 9 is a cross-sectional view of a substrate array in accordance with an embodiment of the invention.

Fig. 10 is a perspective view of a portion of the substrate array of Fig. 9.

Fig. 11 is a cross-sectional view of a substrate array in accordance with another embodiment of the invention.

Fig. 12 is a cross-sectional view of a substrate array in accordance with a further embodiment of the invention.

Fig. 13 is a bottom view of the substrate array of Fig. 12.

DETAILED DESCRIPTION

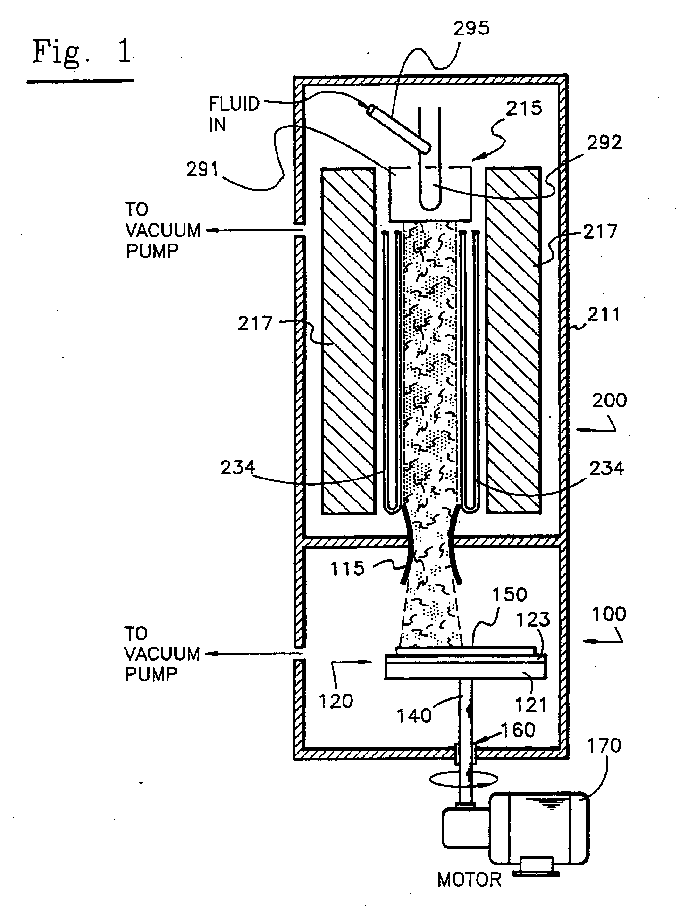

Referring to Fig. 1, there is-shown an embodiment of an apparatus in accordance with the invention and which can be used to practice an embodiment of a method the invention. A deposition chamber 100 is the lower section of a plasma jet deposition system 200, evacuated by one or more vacuum pumping systems (not shown).

The system 200 is contained within a vacuum housing 211 and includes an arc-forming section 215 which comprises a cylindrical anode 291, a rod-like cathode 292, and an injector 295 mounted adjacent the cathode so as to permit injected fluid to pass over the cathode. In the illustrated embodiment the input fluid may be, for example, a mixture of hydrogen and methane. The methane could alternatively be fed in downstream. The anode 291 and cathode 292 are energized by a source of electric potential (not shown), for example a DC potential. Cylindrical magnets, designated by reference numeral 217, are utilized to accelerate and focus the plasma generated at the arc forming section. The magnets maintain the plasma within a narrow column until the plasma reaches the deposition region. A nozzle, represented at 115, can be used to control beam size, within limitations. Cooling coils 234, in which liquid nitrogen can be circulated, are located within the magnets and surround the focused plasma.

In an example of operation, a mixture of hydrogen and methane is fed to the injector 295, and a plasma is obtained in front of the arc forming section and accelerated and focused toward the deposition region. As is known in the art, synthetic polycrystalline diamond can be formed from the described plasma, as the carbon in the methane is selectively deposited as diamond, and the graphite which forms is dissipated by combination with the hydrogen facilitating gas. For further description of plasma jet deposition systems, reference can be made to U.S. Patent No.s 4,471,003 and 4,487,162. It will be understood that other suitable types of plasma beam deposition equipment can be used in conjunction with the features of the invention to be described.

The deposition chamber 100 contains a substrate holder 120 which is mounted on a shaft 140. The holder 120 includes a base 121, and a radiator 123 or other suitable device can be mounted on the base, if necessary or desired. A substrate 150 is mounted on the holder 120, such as by retainer bolts (not shown). [As used herein, the term "substrate" is intended to mean an object having at least one surface on which a substance is to be deposited. It will be understood that a substrate may only temporarily hold a deposited layer which is intended for subsequent removal from the substrate. A substrate may also be an object on which the deposited surface is intended to be permanently affixed; for example, the substrate may be the base of a wear surface of deposited synthetic diamond, such as for ultimate use in a tool.] The shaft 140, non-concentric with the beam, extends through a vacuum-tight feed-through 160 to a motor 170 which spins the shaft 140, holder 120, and substrate 150 at a desired rate during the deposition process. Alternatively, the motor could be located within the vacuum chamber.

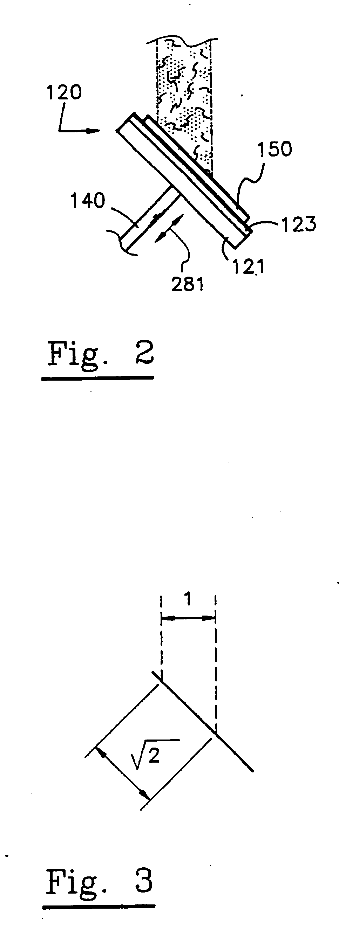

For certain applications, the substrate can be tilted at a substantial angle with respect to the plane perpendicular to the beam direction. This is illustrated in Fig. 2, wherein the substrate 150 is at a substantial angle with respect to the beam 225. [The tilt can be introduced in either the substrate or the beam.] In this example, the plane of the holder 120 (and the corresponding plane of the substrate 150) is at an angle of about 45 degrees with respect to the plane (illustrated by dashed line 295) that is perpendicular to the direction of beam 225. As seen in Fig. 3, for this case the diameter of beam impingement on the substrate is the square root of 2 times the beam diameter. A reciprocating motion (see double-headed arrow 281) can be imparted to the shaft 140 by a reciprocating motor 287 to achieve repetitive coverage on the substrate. If desired, this can be in conjunction with rotating motion imparted to the shaft. However, as such combination of motions can be relatively difficult to implement, a component of motion can be introduced in the plasma beam, such as by introducing controlled gas dynamic instabilities.

Consider the case of a generally cylindrical beam with a generally circular impingement spot on a substrate moving at a velocity V. The beam will cause the spot temperature to change with respect to the substrate by

$$\Delta T = qr/K(\pi B)^{1/2} \qquad (1)$$

where

$$B = \rho V c_p r/K$$

and

q = heat flux
r = radius of source (beam)
K = thermal conductivity of material
$\rho$ = density of material
$c_p$ = specific heat of material
V = linear velocity of heat source

For a particular heat flux and beam geometry, $\Delta T$ will tend to decrease as B increases. B, in turn, will increase with increasing velocity. B also depends on the density and the thermodynamic properties of the substrate material. Selection of substrate materials having favorable properties (i.e., which tend to increase B) will tend to reduce the velocity needed to attain a particular temperature deviation limit. Copper, tungsten, molybdenum, tungsten carbide, and molybdenum carbide have relatively favorable properties for this purpose. Other attributes which should be taken into account pertain to the compatibility with the substance being deposited, including retention of the substance on the substrate, and the relative coefficients of expansion. For a given material, the velocity necessary to have no more than a certain maximum temperature increase can be determined from relationship (1), empirically, or by other suitable means.

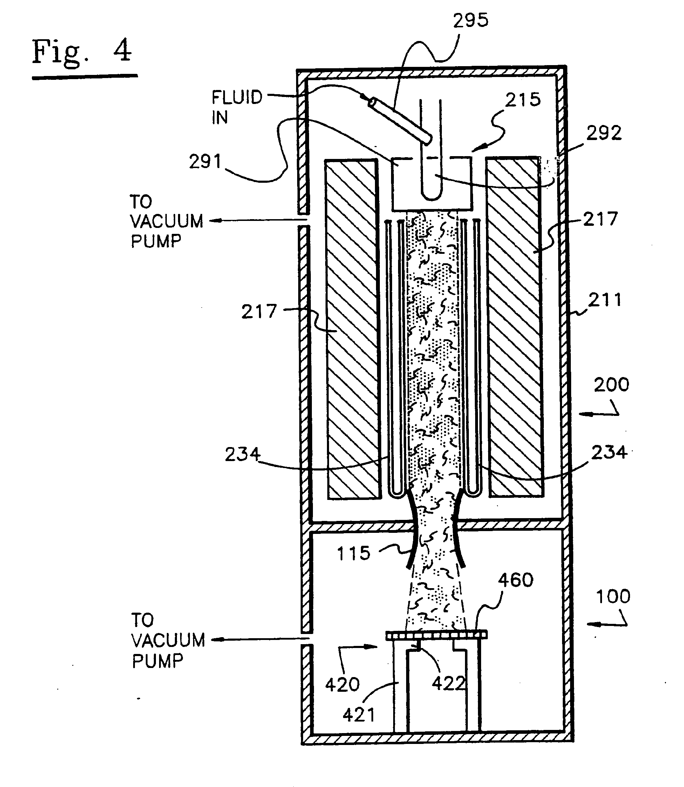

Referring to Fig. 4, there is shown an embodiment of an apparatus in accordance with a further form of the invention and which can be used to practice an embodiment of a method of the invention. The deposition system 200 is generally similar to that of Fig. 1, and like reference numerals represent the same or similar elements.

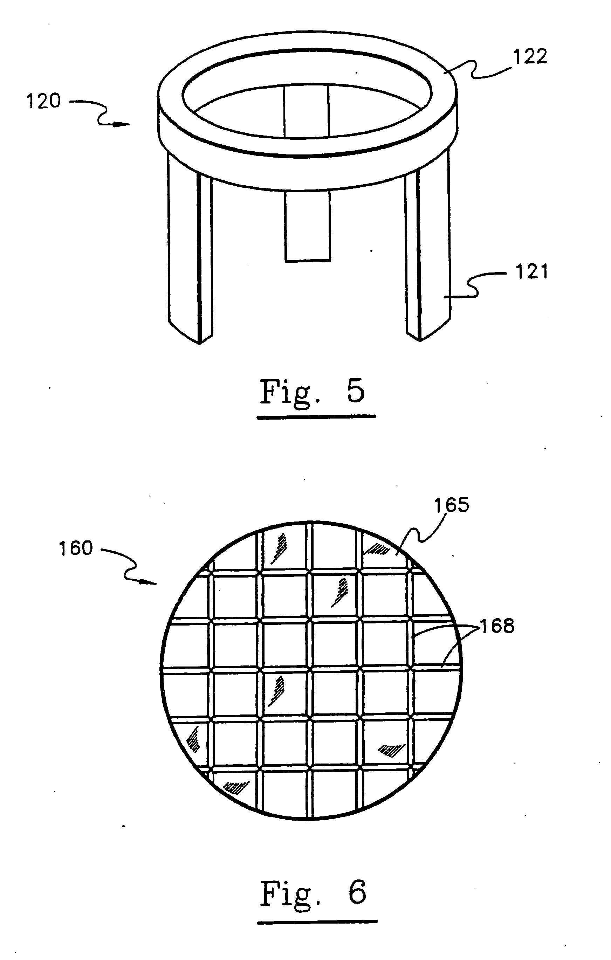

In the embodiment of Fig. 4, the deposition chamber 100 contains a substrate holder in the form of an opened cylindrical stand 420 with legs 421 and an annular base 422 to which a substrate can be secured (see also Fig. 5). A temperature controlling device (not shown) or other suitable device can be mounted on the base, if necessary or de ired. A substrate 460 is mounted on the holder 420, such as by retainer bolts (not shown).

Fig. 6 shows an embodiment of a substrate 460, which has a deposition surface 165 that is shown as being generally flat and has a pattern of grooves 168 which, in this illustration, are in a two-dimensional grid pattern. The grooves preferably have a smooth trough-like contour, although any suitable contour, for example triangular, can be utilized. The grooves extend generally across the substrate and to the edges of the substrate surface. The preferred depth of the grooves can depend on the substrate size and the operating conditions, a suggested minimum depth being about 2 mm. In operation, the grooves facilitate deposition by a plasma beam. As the operative species in the plasma are deposited on the substrate surface, the spent fluids are more readily evacuated from the deposition region by being channeled by the grooves to the edges of the substrate. The grooves also serve to divide the substrate area into relatively smaller individual regions. For some applications, this is advantageous in obtaining deposited films that are less likely to break or crack than larger area films.

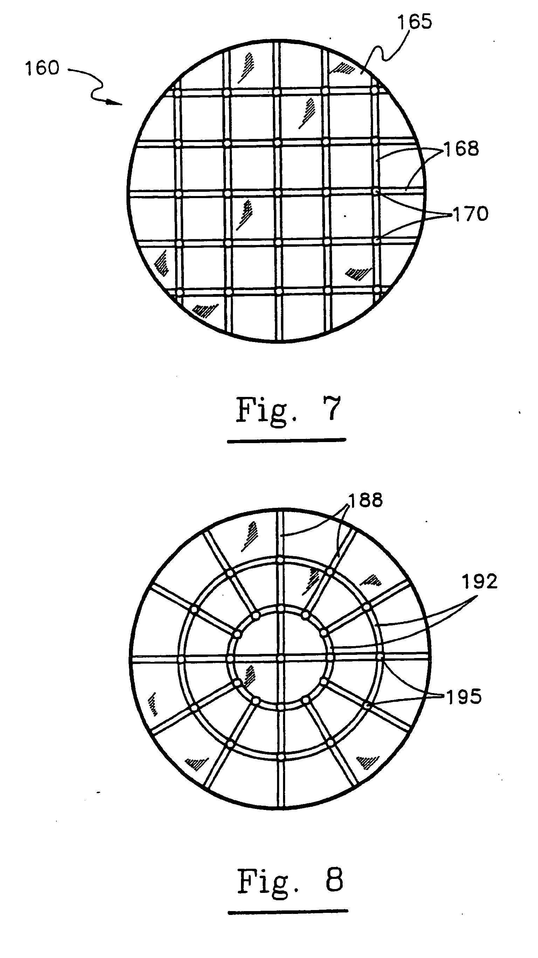

Fig. 7 illustrates a substrate having a groove pattern like that of Fig. 6, but with a plurality of apertures 170 through the substrate. In this example, the apertures are located at the groove intersections. Spent fluids are channelled to the apertures as well as to the edges of the substrate. The apertures may also serve to equalize pressure conditions over the substrate surface to result in more uniform deposition. It will be understood that one or more apertures can be employed, with or without grooves, if desired. Also, in this and other embodiments, the substrate surface can be curved.

Fig. 8 illustrates another example of a substrate configuration with grooves and apertures, this embodiment having radial grooves 188, circular grooves 192 intersecting the radial grooves, and apertures 195 at the intersections. It will be understood that other apertures and/or further apertures can be provided which are not in the grooves or not at the groove intersections.

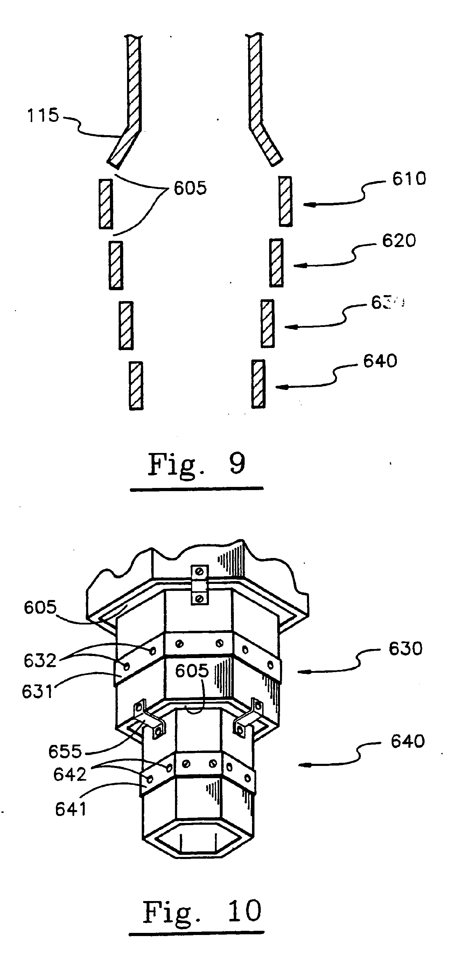

Fig. 9 illustrates a substrate array in accordance with an embodiment of the invention. In this embodiment (see also Fig. 10), the array in the deposition chamber 100 includes a number of substrates having surfaces that are generally parallel to the beam direction. Substrate surfaces at advancing positions in the beam propagation direction (that is, successively further from the plasma beam source) are at successively smaller radial distances from the beam axis. In particular, the embodiment of Fig. 9 shows four groups of substrates 610, 620, 630 and 640 at four successively smaller radial distances from the beam axis as the beam progresses. In the illustrated embodiment, each group of substrate surfaces has a hexagonal cross-section (two substrates of each group being visible in Fig. 9), a perspective view of two adjacent groups (e.g. 630, 640) being illustrated in Fig 10. It will be understood that other arrangements could be employed, for example the group cross-sections could be triangular, rectangular, pentagonal, octagonal, etc. In the illustrated embodiment, the groups of substrates are shown secured together by brackets 631, 641 and bolts 632, 642. Preferably, the contact between substrates and the brackets help to maintain the group at substantially the same temperature. Between the groups of substrates are openings 605 through which the spent fluids can progress toward the vacuum pumping system. Brackets such as 655 can be used between the respective groups, and other supporting structure (not shown), including a stand of the type shown in Fig. 5, can be used to support the substrate array in the deposition chamber or to secure the array, or portions thereof, to the chamber.

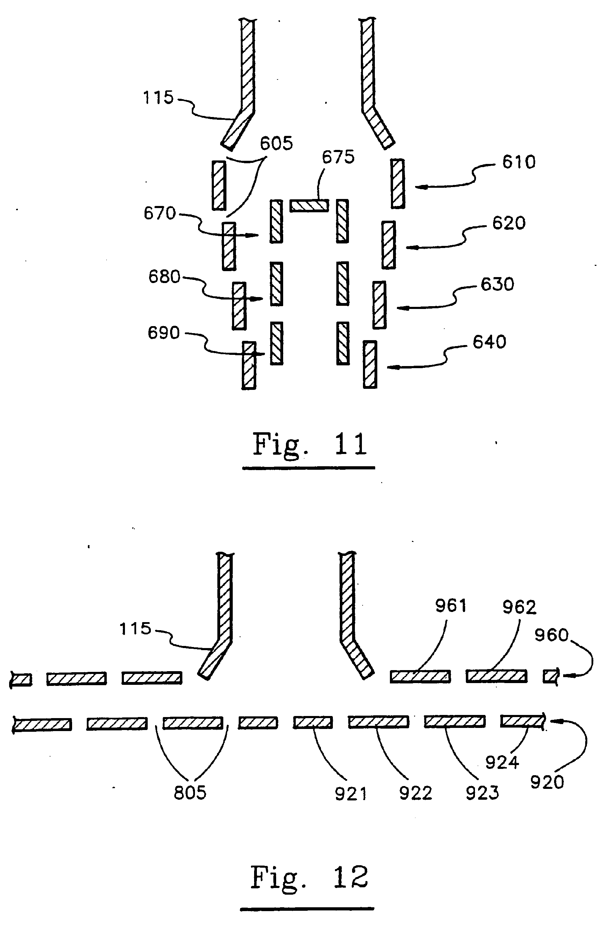

The embodiment of Fig. 11 is like that of Fig. 10, but also has coaxial groups of substrates 670, 680, 690, with openings therebetween, as before. These can also be in hexagonal or other suitable arrangements. A further substrate 675 is shown as being perpendicular to the beam direction and contributes to formation of the beam into a generally annular cross-section, with most of the deposition on the inner surfaces of the substrates of groups 610, 620, 630 and 640, the outer surfaces of the substrates of groups 670, 680 and 690, and the top surface of substrate 675. If desired, the substrate 675 can be omitted, with resulting co-axial flow around the substrate groups 670, 680 and 690, with deposition on both the inner and outer surfaces of the substrates of these groups. In this and other embodiments, supporting structures can be of the types illustrated in Fig.s 5 and 10, or of any suitable type.

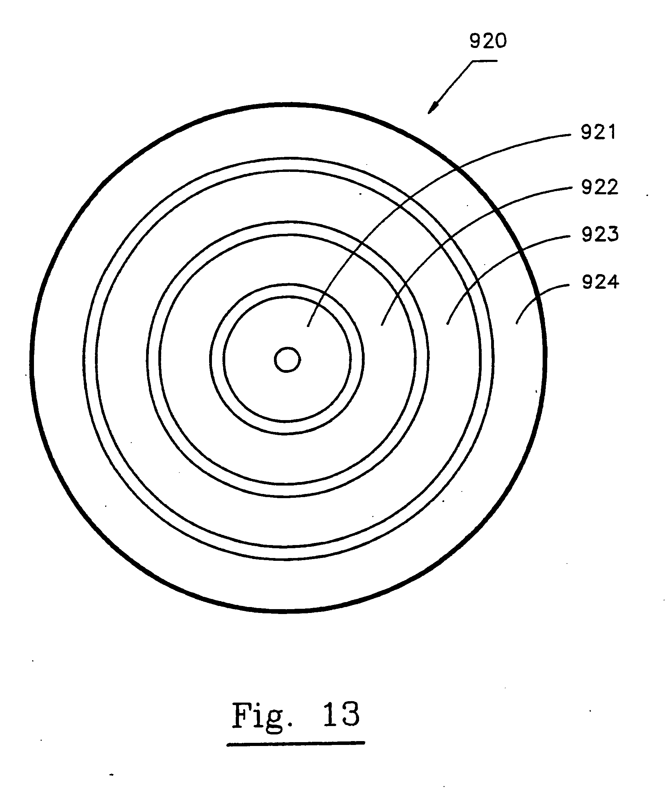

Fig. 12 shows a configuration of substrates in accordance with another embodiment of the invention wherein the plasma beam is formed into a radially propagating beam that is generally enveloped by substrate surfaces. In the illustrated embodiment of Fig. 12, the beam leaving the nozzle 115 encounters a "T" that is formed by annular rings of substrates. The bottom set 920 of substrate rings is shown in Fig. 13, and includes annular rings 921, 922, 923 and 924. Ring 921 has a central aperture, and there are openings 805 between the other rings. The top set 960 of substrate rings includes annular rings 961 (adjacent nozzle 115) and 962. Again, brackets or other suitable supports (not shown) can be provided.

It will be understood that any of the substrates in the embodiments of Fig.s 9-13 can have apertures and/or grooves, as described in conjunction with Fig.s 5-8. Also, the substrates, or arrays thereof, can be tilted and/or moved with respect to the beam, as described in conjunction with Fig.s 13.

**Claims**

1. A method for depositing a substance, comprising the steps of:

   producing a plasma beam containing the constituents of the substance;
   providing a substrate (150) having a surface in the path of the beam, the substrate having at least one aperture through the surface or at least one groove, such that a portion of the beam passes through the at least one aperture or is directed by the at least one groove to the periphery of the surface.

2. The method as defined by claim 1, further comprising providing an aperture and at least one groove (168) in the substrate.

3. The method as defined by claim 1 or claim 2, comprising providing a plurality of apertures.

4. The method as defined by claim 3, further comprising a plurality of grooves (168) in said surface (165), at least some of said grooves terminating at said apertures.

5. The method as defined by claim 4, wherein at least some of said grooves (168) terminate at the periphery of said surface.

6. The method as defined by any one of claims 2-5, wherein an end of the at least one groove (168) terminates at the at least one aperture (195).

7. A method according to any of the preceding claims, comprising providing at least one groove (168) having a minimum depth of 2mm in the surface extending generally across the surface.

8. The method as defined by claim 1 or claim 7, wherein the at least one groove (195) comprises a plurality of grooves.

9. The method as defined by any of the preceding claims, wherein the substrate is synthetic diamond and the plasma beam contains a carbonaceous gas and hydrogen gas.

# Fig. 1

Fig. 2

Fig. 3

# Fig. 4

Fig. 5

Fig. 6

Fig. 7

Fig. 8

Fig. 9

Fig. 10

115

605

670

680

690

675

610

620

630

640

Fig. 11

115

961   962

960

805   921   922   923

924

920

Fig. 12

Fig. 13